(19) Europäisches Patentamt
European Patent Office
Office européen des brevets

(11) Publication number: **0 400 785 B1**

(12) **EUROPEAN PATENT SPECIFICATION**

(45) Date of publication of patent specification: **20.09.95**

(51) Int. Cl.[6]: **C08L 83/08**, C08G 77/388, C08G 77/26

(21) Application number: **90303225.8**

(22) Date of filing: **27.03.90**

(54) **Ultraviolet curable phenyl and acrylamide group-containing silicone compositions.**

(30) Priority: **10.04.89 US 335638**

(43) Date of publication of application:
**05.12.90 Bulletin 90/49**

(45) Publication of the grant of the patent:
**20.09.95 Bulletin 95/38**

(84) Designated Contracting States:
**BE DE FR GB**

(56) References cited:
**EP-A- 0 159 729**
**EP-A- 0 363 071**
**DE-A- 2 944 817**

(73) Proprietor: **DOW CORNING CORPORATION**
**3901 S. Saginaw Road**
**Midland**
**Michigan 48686-0994 (US)**

(72) Inventor: **Lutz, Michael Andrew**
**1815 Wyllys Street**
**Midland,**
**Michigan (US)**
Inventor: **Scheibert, Kristen Andrea**
**291 Genrich Road**
**Sanford,**
**Michigan (US)**

(74) Representative: **Laredo, Jack Joseph et al**
**Elkington and Fife**
**Prospect House**
**8 Pembroke Road**
**Sevenoaks, Kent TN13 1XR (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

Polyorganosiloxanes which are curable by exposure to ultraviolet radiation are useful materials. However, many of the additional ingredients which can be used to make compositions from them often create the problem of incompatibility. Compositions which exhibit the incompatibility problem may be of the simplest kind, namely the polyorganosiloxane and a photoinitiator. The well-known photoinitiators are organic compounds. Many of these photoinitiators exhibit incompatibility with the polyorganosiloxanes and some photoinitiators are so incompatible with the polyorganosiloxanes that they are not really useful. To overcome this incompatibility problem with the photoinitiators, it is known in the art to react some of them with polyorganosiloxanes, so that the photoactive function of the photoinitiator still functions but, because it is chemically attached to polyorganosiloxane, the incompatibility problem is resolved. Although this approach is useful for some applications and for some photoinitiators, it is not an entirely satisfactory solution to overcome the incompatibility observed for other kinds of non-silicon containing ingredients, such as reactive diluents.

Because acrylamide-functional polyorganosiloxanes are useful materials in ultraviolet radiation-curable compositions, it is desirable to find means to make compositions with properties ranging from soft gels to tough materials. To achieve the tougher materials, additives can be used, but because these additives are often non-silicon containing, they are incompatible with the acrylamide-functional polyorganosiloxanes and, therefore, making useful compositions, especially without the use of organic solvents, is difficult.

EP-A-0 159 729 discloses ultraviolet radiation-curable compositions of acrylate-functional polyorganosiloxanes comprising dimethylsiloxane monomeric units and at least one siloxane selected from the group consisting of methylphenyl siloxane and di-phenylsiloxane and photosensitization systems comprising photoinitiators.

This invention relates to a composition comprising a compatible mixture of (I) an acrylamide-functional polyorganosiloxane having an average unit formula:

$$Y_aR_bSiO_{(4-a-b)/2}$$

in which R is a monovalent organic group where 5 to 50 mole percent of R are aromatic based on all R equal to 100 mole percent, Y is an acrylamide-functional group bonded to the silicon atom through a silicon-carbon bond, a has a value such that there is on the average at least 0.4 acrylamide functional groups per molecule, b has a value in the range of from 0.7 to 2.02 and the sum of a+b is at least 0.7, said polyorganosiloxane being applicable to a substrate and curable by exposure to ultraviolet radiation, and (II) a photosensitization system.

Polyorganosiloxanes which contain the acrylamide functionality useful in the compositions of this invention are those which contain from 5 to 50 mole percent, preferably from 20 to 50 mole percent aromatic groups, based on the total number of the organic groups on the silicon atoms, less the acrylamide-functional groups. They may contain any combination of siloxane units, and, therefore, the structure will vary widely, and include linear branched, three-dimensional network, cyclic and like units. The siloxane units may be monoorganosilsesquioxane, diorganosiloxane, triorganosiloxy or $SiO_2$ units. The acrylamide functionality may be on any of the organic group-containing siloxane units; however, the preferred polyorganosiloxanes are the linear polydiorganosiloxanes which are essentially composed of diorganosiloxane units.

These acrylamide-functional polyorganosiloxanes are an unique class of siloxane polymers for use in ultraviolet radiation-curable compositions. The polyorganosiloxanes of the compositions of the invention exhibit a number of improvements in such compositions. Such improvements are a result of the amount of aromatic groups which the polyorganosiloxane contains. The aromatic-containing acrylamide-functional polyorganosiloxanes have a compatibility with a greater number of non-silicon compounds, e.g., photoinitiators, reactive diluents, adhesion additives, flow control agents and stability additives, than acrylamide-functional polyorganosiloxanes which contain less than 5 mole percent aromatic groups on the siloxane polymer. The number of non-silicon compounds which are compatible with these siloxane polymers increases as the aromatic content of the polyorganosiloxane increases. The polyorganosiloxanes of the invention provide compositions which cure to products having improved low temperature flexibility and, contrary to the teachings of the art, such as Sato et al. US-A-4364809, compositions which contain the aromatic-containing, acrylamide-functional polyorganosiloxanes can cure faster as the mole percentage of aromatic groups increases.

Ingredients of compositions made from the aromatic group-containing, acrylamide-functional polyorganosiloxanes defined herein which show improved compatibility are the photoinitiators. The photoinitiator is

used in amounts sufficient to provide the desired cure of the composition. The amount of photoinitiator can be increased as the mole percentage of aromatic group increases in the acrylamide functional polyorganosiloxane because the compatibility of the photoinitiator in the composition increases. Polyorganosiloxanes which contain no aromatic groups are limited as to both the kind and amount of photoinitiator which can be used in the ultraviolet radiation-curable compositions, because they are incompatible at higher concentrations, or because they become incompatible as the composition cures, and precipitate from the material. This unique class of acrylamide-functional polyorganosiloxanes provides the ability to make compositions which can have cure characteristics designed for the specific application, and the kind and amount of photoinitiator can be selected to achieve the desired results without having the compatibility of the photoinitiator in the composition dictating the cure characteristics.

The photosensitization system is, in the simplest form, a photoinitiator. However, it may also include other ingredients which provide some function to the photocurable process, such as chain transfer agents, for example, amines, especially tertiary amines. Other ingredients are known in the art.

Examples of photoinitiators include benzoin; benzoin alkyl ethers such as methyl, ethyl, isopropyl and isobutyl benzoin ethers; acetophenone derivatives, such as dialkoxyacetophenone exemplified by diethoxyacetophenone, dichloroacetophenone, trichloroacetophenone, alpha,alpha-dimethoxy-alpha-phenylacetophenone, 1-hydroxycyclohexylphenyl methanone, 2-hydroxy-2-methyl-1-phenylpropane-1-one, methylphenyl glyoxylate, 4-benzoylbenzyl-trimethylammonium chloride, alpha-acyloxime esters such as 1-phenyl-1,2-propanedione-2-(O-ethoxycarbonyloxime), benzophenone in combination with a chain transfer agent such as an amine, especially a tertiary amine and azo-bis(isobutyronitrile), benzil ketals and ketone amine derivatives. Polysilanes are useful in the compositions which are to be cured by ultraviolet radiation. The polysilane photoinitiators are those which have a chain of catenated silicon atoms in either a linear configuration or in a ring configuration. The polysilane must be soluble in the blend. The polysilanes can be the phenylmethylpolysilanes defined by West in U.S. Patent No. 4,260,780, issued April 7, 1981; the aminated methylpolysilanes defined by Baney et al. in U.S. Patent No. 4,314,956, issued February 9, 1982; the methylpolysilanes of Peterson et al. in U.S. Patent No. 4,276,424, issued June 30, 1981; and the polysilastyrene defined by West et al. in U.S. Patent No. 4,324,901, issued April 13, 1982.

Photoinitiators which are particularly useful in these compositions include;

$C_6H_5\text{-}C(O)C(CH_3)_2\text{-}OH$,

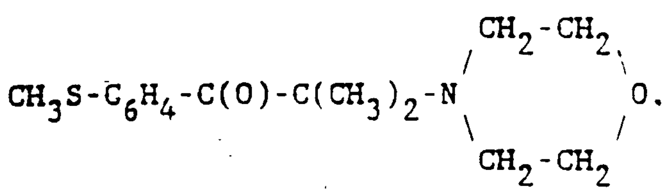

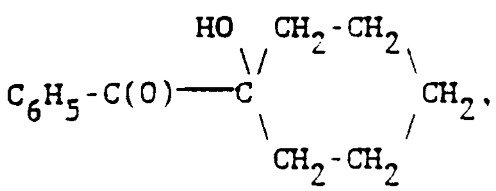

and benzoin methyl ether.

Reactive diluents are often used in ultraviolet radiation-curable compositions to provide crosslinking and to reinforce and to strengthen the cured products. However, polyorganosiloxanes do not readily make compatible compositions with these reactive diluents and the choice of the kind and amount of reactive diluent is limited because of this incompatibility problem. Limiting the kinds and amounts of reactive diluents also limits the properties which can be achieved with ultraviolet radiation-curable compositions based on polyorganosiloxanes, for example, the acrylamide-functional polyorganosiloxanes. The unique class of aromatic group containing, acrylamide functional polyorganosiloxanes provides a broader spectrum of kinds of reactive diluents and amounts of such reactive diluents which can be used to make ultraviolet radiation curable compositions. In US-A-4824875 entitled "UV CURABLE CONFORMAL COATING WITH MOISTURE SHADOW CURE", the reactive diluents are limited to isobornyl acrylate, cyclohexyl acrylate and 2-ethylhexyl acrylate because others are incompatible and of these three reactive diluents, the isobornyl acrylate is the preferred because of the compatibility with the polyorganosiloxanes of the

composition which are methylsiloxanes. Isobornyl acrylate is useful but has a very undesirable odor. The use of the aromatic group containing, acrylamide functional polyorganosiloxanes having from 5 to 50 mole percent aromatic groups bonded to the silicon atoms permits one to select many other kinds of reactive diluents and thus the odor can be eliminated or at least substantially reduced. In addition to the above reactive diluents, others which are compatible with the polyorganosiloxanes containing the aromatic groups include hexanediol diacrylate, butanediol diacrylate, trimethylolpropane trimethacrylate, vinyl acetate, tetrahydrofurfuryl acrylate, trimethylolpropane triacrylate, phenoxyethyl acrylate and tripropylene glycol diacrylate.

The acrylamide functional polyorganosiloxanes of this invention contain organic groups bonded to the silicon atoms (other than the acrylamide functional groups) which are from 5 to 50 percent aromatic, preferably phenyl, with the remainder being othe, organic groups, preferably methyl. The acrylamide functional polyorganosiloxanes have the average unit formula

$$Y_aR_bSiO_{(4-a-b)/2}$$

which describes the class of polymers. R represents the organic groups which are non-acrylamide functional and which are from 5 to 50 percent aromatic. R is a monovalent radical where 5 to 50 mole percent are aryl radicals such as phenyl, 2-phenylethyl and benzyl and the remainder are alkyl radicals such as methyl, ethyl, propyl, butyl and cyclohexyl or a fluorinated alkyl radical such as 3,3,3-trifluoropropyl, 2-(perfluoro-ethyl)ethyl and 2-(perfluorobutyl)ethyl. Y is an acrylamide functional group bonded to the silicon atoms through a silicon-carbon bond. These acrylamide functional groups are preferably acrylamidoalkyl or methacrylamidoalkyl. a represents the number of Y groups per silicon atom of the average unit formula and has a broad range, but should be such that there is at least 0.4 acrylamide functional groups per molecule and can be as high as 0.5 acrylamide functional groups per silicon atom of the average unit formula. However, the preferred acrylamide functional polyorganosiloxanes which can be used to make compositions which can be applied to substrates and cured by exposure to ultraviolet radiation usually do not have more than 0.1 acrylamide functional groups per silicon arom. The preferred value of a is from 0.001 to 0.04. b has a value such that the resulting acrylamide functional polyorganosiloxane can be applied to a substrate and also cured by exposure to ultraviolet radiation. This value for b is such that the polyorganosiloxane can be used to make compositions have a viscosity or can be made to have a viscosity such as by reactive diluents where said compositions can be coated on substrates. b ranges from 0.7 to 2.02. The value of b is such that the acrylamide functional polyorganosiloxane will cure when exposed to ultaviolet radiation and either does not cure spontaneously when prepared or will not cure even after exposed to ultraviolet radiation in the presence of a photoinitiator. The sum of a+b is at least 0.7 and preferably ranges from 0.7 to 2.02.

The acrylamide functionality, Y, is bonded to silicon atoms of the polyorganosiloxane molecules through silicon-carbon bonds and has a formula

Formula I

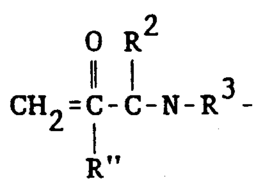

or the formula

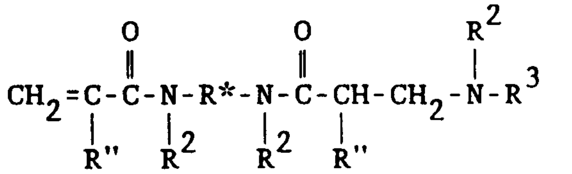

Formula II

in which R″ is hydrogen atom or methyl and $R^2$ is hydrogen atom or an alkyl of 1 to 4 carbon atoms, such as methyl, ethyl, propyl, isopropyl, butyl, isobutyl or tertiary butyl. $R^3$ is a divalent hydrocarbon radical having 1 to 10 carbon atoms per radical such as methylene, ethylene, butylene, hexylene, propylene,

decylene, $-C_6H_4-$, $-CH_2CH_2C_6H_4-$,

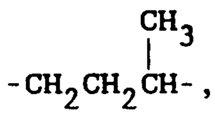
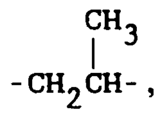 and 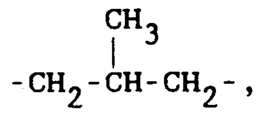

where the preferred $R^3$ are those having 2 to 6 carbon atoms per radical such as ethylene, propylene, isopropylene, butylene, isobutylene, tertiary butylene, pentylene and hexylene. $R^*$ is a divalent hydrocarbon radical. Examples of $R^*$ as a divalent hydrocarbon radical include methylene, ethylene, propylene, butylene, hexylene, decylene,

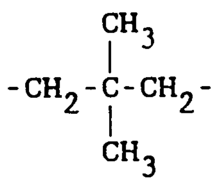
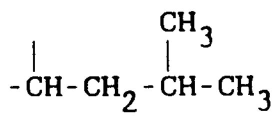 and 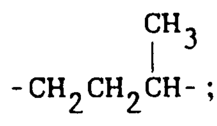

Acrylamide functional polyorganosiloxanes which cure by exposure to ultraviolet radiation are known in the art, for example, Morehouse in U.S. Patent No. 2,929,829, issued March 22, 1960, teaches that acrylamide compounds can be made by reacting acyl halides with aminoalkyl silicon compounds to produce acylamide functional silicon compounds. Morehouse teaches the following reaction

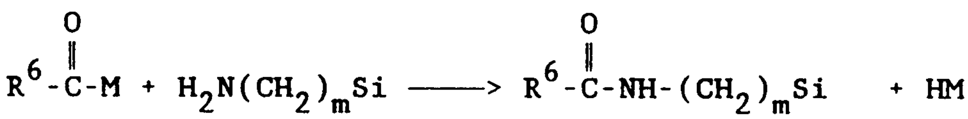

wherein $R^6$ is an alkyl, aryl, alkenyl or a monovalent heterocyclic ring, M is a halogen atom and m is an integer of at least 3. When $R^6$ is vinyl and M is chlorine, the halogen compound is acryloyl chloride and the product formed would be an acrylamide functional silicon compound. Morehouse shows a method of preparing acrylamide functional polyorganosiloxanes which can be used in this invention.

The polyorganosiloxanes having acrylamide functionality are taught by Varaprath in U.S. Patent No. 4,608,270, issued August 26, 1986, shows methods of preparing polyorganosiloxanes having acrylamide functionality. The polyorganosiloxanes of this invention made by the Varaprath methods would have the following average unit formula

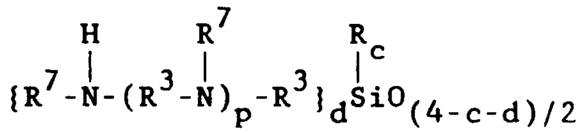

wherein R and $R^3$ are defined above, p is 0 or 1, each $R^7$ is independently $R^2$ or

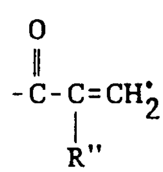

where at least one $R^7$ per molecule is

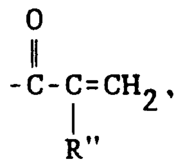

where $R^2$ and R″ are defined above, $\underline{c}$ has a value of from 0 to 2.05, $\underline{d}$ has a value such that there are at least 0.4 acrylamide functional groups per molecule and up to 0. 5 acrylamide functional groups per silicon atom, preferably $\underline{d}$ is from 0.001 to 0.04 and $\underline{c+d}$ has a value of from 0.7 to 2.05. For convenience, Z will be used to represent the acrylamide functional group of the formula

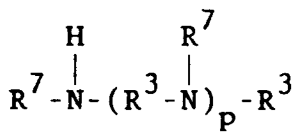

The polyorganosiloxanes preferably contain siloxane units which are free of acrylamide functional radicals such as $MeSiO_{3/2}$, $Me_2SiO_{2/2}$, $MeViSiO_{2/2}$, $MePhSiO_{2/2}$, $Me_3SiO_{1/2}$, $Me_2(OR^9)SiO_{1/2}$, $ViMe_2SiO_{1/2}$, $Ph_2SiO_{2/2}$ and $SiO_{4/2}$ units, in addition to siloxane units which contain the required number of acrylamide functional substituted hydrocarbon radicals. $R^9$ is an alkyl radical having from 1 to 4 carbon atoms. Symbols Me, Ph and Vi, as used herein refer respectively to methyl, phenyl and vinyl. The polyorganosiloxanes can contain acrylamide functional groups which have unreacted amine hydrogen atoms such as

$YHNCH_2CH_2NHCH_2CH(CH_3)CH_2Si(CH_3)O_{2/2}$.

Preferred polyorganosiloxanes used in the compositions of this invention are the polydiorganosiloxanes which have the formula $Z'R_2SiO(R_2SiO)_x(Z'RSiO)_ySiR_2Z'$ wherein each Z′ denotes, independently, an R radical or Y as described above and $\underline{x}$ and $\underline{y}$ denote numbers having average values of from 10 to 5000 and 0 to 500, respectively. The polydiorganosiloxane has on the average at least 0.4 Y per molecule. Examples of preferred polydiorganosiloxanes include.

$Me_3SiO(Me_2SiO)_{298}(MePhSiO)_{202}(MeZ'SiO)_2SiMe_3$,

$Z'Me_2SiO(Me_2SiO)_{1800}(MePhSiO)_{400}SiMe_2Z'$, and

$Z'Me_2SiO(Me_2SiO)_{100}(Ph_2SiO)_7(MeZ'SiO)_3SiMe_2Z'$.

The polyorganosiloxanes having acrylamide functionality can be prepared by admixing an acryloyl halide with an amino functional polyorganosiloxane having per molecule on the average at least 0.4 silicon-bonded amino-substituted hydrocarbon radicals containing at least one nitrogen-bonded hydrogen and from 5 to 50 mole percent phenyl radicals. The mixture is reacted by using an aqueous solution of a water-soluble alkaline material and a water-insoluble solvent for the amino functional polyorganosiloxane. There should be present at least one acryloyl chloride per one amino hydrogen atom to be converted to acrylamide functionality and at least an equivalent amount of alkaline material relative to the amount of acryloyl chloride. It is to be understood that when acryloyl chloride is referred to, one can substitute methacryloyl chloride.

The amino functional polyorganosiloxanes can contain per molecule, on the average, at least 0.4 amino functional groups which have at least one amino hydrogen atom for conversion into an acrylamide functional group. The silicon-bonded amino-substituted hydrocarbon radical has the formula which is referred to hereinafter, for convenience, as Z″:

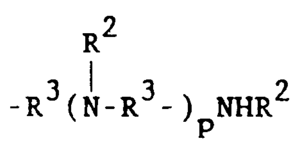

wherein $R^2$ and $R^3$ are defined above and $\underline{p}$ has a value of 0 or 1. Examples of amino-substituted hydrocarbon radicals (amino functional) include, $H_2NCH_2CH_2CH_2$-, $CH_3NHCH_2CH_2CH_2$-, $H_2NCH_2CH(CH_3)$-

$CH_2$-, $H_2NCH_2CH_2NHCH_2CH_2CH_2$-, $H_2NCH_2CH_2NHCH_2CH(CH_3)CH_2$-, $H_2N(CH_2)_6NH(CH_2)_3$-, $H_2N(CH_2)_6NHCH_2CH(CH_3)CH_2$-, $H_2N(CH_2)_2N(CH_3)CH_2CH_2CH_2$- and $CH_3NHCH_2CH(CH_3)CH_2$-.

The amino functional polyorganosiloxane can be siloxanes having the average unit formula

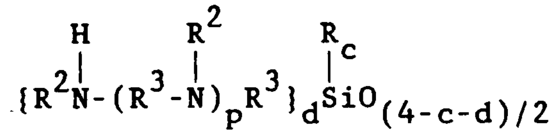

wherein R, $R^2$, $R^3$, p, c and d are defined above. The polyorganosiloxanes can contain siloxane units which are free of amino-substituted hydrocarbon radicals, such as $MeSiO_{3/2}$,$Me_2SiO_{2/2}$, $Me_3SiO_{1/2}$, $MeViSiO_{2/2}$, $MePhSiO_{2/2}$, $Me_2(OR^9)SiO_{1/2}$, $ViMe_2SiO_{1/2}$ and $SiO_{4/2}$ units, in addition to siloxane units which contain the required amino-substituted hydrocarbon radicals.

Preferred amino functional polyorganosiloxanes to be converted into acrylamide functionality have the formula $Z^2R_2SiO(R_2SiO)_x(Z^2RSiO)_ySiR_2Z^2$ wherein each $Z^2$ denotes, independently, an R radical or a Z″ radical and x and y denote numbers having average values of from 10 to 5000 and 0 to 500, respectively and from 5 to 50 mole percent of the R are phenyl. The amino functional polydiorganosiloxane have per molecule on the average at least 0.4 Z″ per molecule. Examples of preferred amino functional polydiorganosiloxanes to be converted into acrylamide functionality include

$Me_3SiO(Me_2SiO)_{298}(MePhSiO)_{202}(MeZ^2SiO)_2SiMe_3$,
$Z^2Me_2SiO(Me_2SiO)_{1800}(MePhSiO)_{400}SiMe_2Z^2$, and
$Z^2Me_2SiO(Me_2SiO)_{100}(Ph_2SiO)_7(MeZ^2SiO)_3SiMe_2Z^2$.

Amino functional polyorganosiloxanes are well known in the organosilicon art and need no detailed description as to their preparation. The disclosures of Sommer in U.S. Patent No. 2,557,803, issued June 19, 1951; Speier in U.S. Patent No. 2,738,357, issued March 3. 1956; Elliott in U.S. Patent No. 2,754 312, issued July 10. 1956; Speier in U.S. Patent No. 2,762,823, issued September 11, 1956; U.S. Patent No. 2,998,406; U.S. Patent No. 3,045,036; Morehouse in U.S. Patent No. 3,087,909, issued April 30, 1963; Brown in U.S. Patent No. 3,355,424, issued November 28, 1967; Plueddemann in U.S. Patent No. 3,560,543, issued February 2, 1971; U.S. Patent No. 3,890,269; U.S. Patent No. 4,036,868; Seiler et al in U.S. Patent No. 4,152,346, issued May 1, 1979; and Tangney et al in U.S. Patent No. 4,507,455, issued March 26, 1985 further teach how to prepare amino functional polyorganosiloxanes.

The acrylamide functional polyorganosiloxane is made by admixing the acryloyl halide with the amino functional polyorganosiloxane in the presence of an aqueous solution of an alkaline material. The alkaline material can be any water-soluble material having a $pK_b$ value greater than the $pK_b$ of the amine radicals in the amino-substituted hydrocarbon radicals to be converted into the acrylamide functionality. The alkaline material is preferably an alkali metal hydroxide such as sodium hydroxide or potassium hydroxide.

In addition to the aqueous solution of alkaline material, there is also present a water-insoluble solvent for the amino functional polyorganosiloxane when the acryloyl halide is admixed with the amino functional polyorganosiloxane. Said solvent can be any suitable liquid that will not react with the components of the reaction. Preferably, the solvent is also a solvent for the acrylamide functional polyorganosiloxane product of the reaction.

Examples of suitable solvents include hydrocarbons such as toluene, xylene, hexane, cyclohexane and heptane, halogenated hydrocarbons such as methylene chloride, chloroform, trichloroethylene and trichloroethane; and oxygenated compounds such as ethyl ether and ethyl acetate. Mixtures of two or more solvents can also be used, it only being required in this instance that the mixture and not necessarily all the components in the mixture, be a solvent for the amino functional polyorganosiloxane.

The acryloyl halide, the amino functional polyorganosiloxane, the aqueous solution of alkaline material and solvent, can be mixed in any manner, as long as, the acryloyl halide is added to the amino functional polyorganosiloxane in the presence of the alkaline material and the solvent. Preferably the acryloyl halide or a solution thereof, is added to a well agitated mixture of aqueous alkaline material and solvent solution of amino functional polyorganosiloxane. The reaction should be carried out at a temperature of from about 0 °C. to 10 °C. to minimize the production of undesirable by-products and to increase the conversion.

The amounts of the components to be used in this method are not narrowly critical, it only being necessary to have present a sufficient amount of alkaline material to neutralize all hydrogen halide as it is produced when the acryloyl halide reacts with the nitrogen-bonded hydrogen atoms and a sufficient amount of acryloyl halide to convert the amount of amino functionality to acrylamide functionality as desired.

The alkaline material and the acryloyl halide are preferably used in equivalent amounts; e.g. one molecule of sodium hydroxide for every molecule of acryloyl chloride, although an excess of the alkaline material relative to the amount of hydrogen halide produced has not been found to be detrimental to the desired result of the reaction. A deficiency of alkali ne material relative to the amount of hydrogen halide produced is to be avoided.

The amount of water that is used in this method should be sufficient to dissolve the alkaline material and, preferably, provide a less-than-saturated solution thereof. A 2% solution of sodium hydroxide has been found to be desirable.

The amount of solvent that is used in this method should be sufficient to dissolve the amino functional polyorganosiloxane and, preferably, the acrylamide functional polyorganosiloxane product as well.

During and after the addition of the acryloyl halide to the amino functional polyorganosiloxane, the reaction mixture should be thoroughly agitated to maintain an intimate contact between the aqueous and nonaqueous phases. Low shear means such as stirrers, paddles and impellers are sufficient to maintain the agitation until the acrylation reaction is finished, typically within an hour.

After the reaction is finished and the organic phase is separated from the aqueous phase, the product of the reaction (in the organic phase) is separated from the solvent. It may be desirable to add a polymerization inhibitor to the solution prior to any separating action, such as distilling or fractionating, to avoid undesirable polymerization of the acrylamide groups.

In particular, curable compositions of this invention which are useful for coating can be made from, a fully acrylated polydiorganosiloxane having the formula

$YR_2SiO(R_2SiO)_z(YRSiO)_gSiR_2Y$

wherein Y and R have the meanings noted above where 5 to 50 percent of the R are phenyl, $\underline{z}$ has a value of from 10 to 2000 and $\underline{g}$ has a value of from 0 to 0.1$\underline{z}$. Preferably, the acrylamide functional polydiorganosiloxane having the above formula has a viscosity of from 100 to 10,000 centipoise when the curable composition is to be used as a solventless coating composition.

Examples of acrylamide functional polydiorganosiloxanes having the above formula include

$YMe_2SiO(Me_2SiO)_z(MePhSiO)_uSiMe_2Y$,

$Me_3SiO(Me_2SiO)_z(MePhSiO)_u(YMeSiO)_hSiMe_3$ and

$YMe_2SiO(Me_2SiO)_z(MePhSiO)_u(YMeSiO)_hSiMe_2Y$,

wherein $\underline{h}$ has a value of from greater than 0 to 0.1$\underline{z}$, $\underline{u}$ has a value such that there is present from 5 to 50 mole percent Ph based on the total number of Me and Ph and $\underline{z}$ has the meaning noted above. In these polydiorganosiloxanes, $\underline{h}$ has a value such that the polydiorganosiloxane contains on the average at least 0.4 acrylamide functional groups per molecule. Compositions prepared from acrylamide functional polydiorganosiloxanes which have on the average one, two or more are very useful for making ultraviolet radiation curable coating materials.

In our copending European application, EP-A-0396246 (Inventor: Michael A. Lutz) entitled "ULTRAVIOLET CURED GELS WITH CONTROLLED MODULUS AND VISCOSITY", acrylamide functional polydiorganosiloxane compositions which cure to gels by exposure to ultraviolet radiation and are useful for coating, encapsulating and potting electronic devices which have fragile components are shown.

These compositions having gel-like properties are unique in that their hardness can have a predetermined durometer at a predetermined viscosity, i.e. the viscosity of the uncured composition and the hardness of the cured composition can be independently controlled. These compositions comprise a blend of acrylamide functional polydiorganosiloxanes and a photosensitization system for curing the blend when irradiated with ultraviolet radiation, wherein the blend is (A) 4 to 90 mole percent of an acrylamide functional endblocked polydiorganosiloxane of the general formula

$YR'_2SiO(R_2SiO)_nSiR'_2Y$,

(B) 9 to 50 mole percent of a mono-acrylamide functional endblocked polydiorganosiloxane of the general formula

$R'_3SiO(R_2SiO)_nSiR'_2Y$,

and (C) 0 to 65 mole percent of a non-functional polydiorgano-siloxane of the formula

$R'_3SiO(R_2SiO)_nSiR'_3$

where, in the above formulae, R is a monovalent radical selected from the group consisting of alkyl, aryl and fluorinated alkyl where from 5 to 50 mole percent R is aryl; each R′ is independently selected from the group consisting of R, hydroxyl and a hydrolyzable group, Y is an acrylamide functional radical bonded to silicon atom through silicon-carbon bond where the acrylamide function has Formula I or Formula II in which R″ is hydrogen atom or methyl, $R^2$ is hydrogen atom or an alkyl of 1 to 4 carbon atoms, $R^3$ is a divalent hydrocarbon radical having from 1 to 10 carbon atoms per radical, R* is a divalent hydrocarbon radical or a divalent hydrocarbon radical containing ether linkages and $\underline{n}$ has a value of from 30 to 3,000, the mole percentages being based on the total blend as 100 mole percent and where the polydiorganosiloxanes of the blend are present in amounts to provide 20 to 95 percent of the endblocking as acrylamide functionality and 5 to 80 percent of the endblocking as non-functional.

The acrylamide functional polydiorganosiloxanes of (A) are those which have two acrylamide functions per molecule, one per terminating or endblocking siloxane unit and has the general formula

$YR'_2SiO(R_2SiO)_nSiR'_2Y,$

in which Y, R, R′ and $\underline{n}$ are defined above. Each R′ is independently selected from hydroxyl, a radical represented by R or a hydrolyzable radical bonded to a silicon atom such as alkoxy illustrated by methoxy, ethoxy, isopropoxy, butoxy and isobutoxy or other non-corrosive hydrolyzable groups such as isopropenoxy, acetamido and ketoximo. The acrylamide functional polydiorganosiloxanes of (A) can have a degree of polymerization such that the value of $\underline{n}$ ranges from 30 to 3,000, preferably from 50 to 1,000, in which the preferred diorganosiloxane units are selected from the group consisting of dimethylsiloxane, phenylmethylsiloxane, diphenylsiloxane and methyl-(3,3,3-trifluoropropyl)siloxane.

Acrylamide functional polydiorganosiloxanes of (A) can be those in which the acrylamide is N-alkyl-N-acrylamide or N- alkyl-N-methacrylamide. The acrylamide polydiorgano-siloxane of (A) contains two acrylamide functional groups bonded to silicon atoms through Si-C bonds on the terminal silicon atoms of the polymer chain. The remaining organic groups bonded to the silicon atoms of the polyorganosiloxane are defined above for R and are preferably methyl, phenyl or 3,3,3-trifluoropropyl. The acrylamide functional polydiorganosiloxanes can be made as described by Varaprath cited above and shows methods for the preparation of the polyorganosiloxanes with acrylamide functionality on the chain terminals. The siloxane units can include dimethylsiloxane units, diphenylsiloxane units, methylphenylsiloxane units, methyl-3,3,3-trifluoropropylsiloxane units and siloxane units having an acrylamide functional group of Formula I in which $R^2$ is hydrogen atom or an alkyl radical of one to four carbon atoms such as methyl, ethyl, propyl or butyl, $R^3$ is a divalent hydrocarbon radical of 2 to 6 carbon atoms, such as ethylene, propylene, isobutylene and hexylene. When R″ is hydrogen, the acrylamide functionality is the acrylyl radical and when R″ is methyl, the acrylamide functionality is the methacrylyl radical. Polydiorganosiloxanes endblocked with

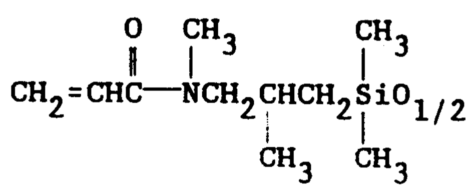

are preferred.

The mono-acrylamide functional endblocked polydiorganosiloxanes of (B) are not particularly well known but can be prepared by many of the methods used to prepare the acrylamide functional polydiorganosiloxanes of (A). The mono-acrylamide functional endblocked polydiorganosiloxanes of (B) are made by first preparing a polydiorganosiloxane in which some of the endblocking units are triorganosiloxy in which the organic groups are alkyl, aryl or fluoroalkyl and the remainder of the endblocking units are hydroxyl. Dupree shows such polymers in U.S. Patent No. 3,274,145 issued September 20, 1966.

The mono-acrylamide functional endblocked polydiorganosiloxanes of (B) can be prepared by several methods by selecting the proper starting materials. It is difficult to prepare the polydiorganosiloxanes of (B) in the pure form, that is, where all the molecules have one non-functional endblock and one acrylamide functional endblock. Most of the economical methods of the preparation of polydiorganosiloxanes involves the use of equilibration methods and these methods produce statistical distributions of molecular species. For example, the preparation of polydiorganosiloxane (B), in which the acrylamide functional endblock uses

the method of reacting a silane with hydroxyl endblocked polydiorganosiloxane in the presence of a catalyst, can be used if a starting polydiorganosiloxane is one in which some of the molecules have one hydroxyl endblock and one non-functional endblock such as a trimethylsiloxy unit. Such polydiorganosiloxanes are known from Dupree which shows the polydiorganosiloxane with some of the molecules having one hydroxyl endblock. These hydroxyl endblocked polydiorganosiloxanes will contain a distribution of molecules such that some of the molecules will have two hydroxyl endblocking groups, some of the molecules will have one hydroxyl endblocking group and one non-functional endblocking group (a triorganosiloxy unit) and some of the molecules will have two non-functional endblocking groups (triorganosiloxy units). The amount of each type of polydiorganosiloxane which is in the polymer mixture will depend upon the ingredients used to prepare it. Polydiorganosiloxanes used for (B) can be controlled best by selecting a method which will provide the desired number of molecules with one hydroxyl endblock. The number of acrylamide functional endblocked polydiorganosiloxane (A) molecules and the number of non-functional polydiorganosiloxanes (C) can then be varied to make a variety of blends. Starting with a polydiorganosiloxane with hydroxyl endblocks such as described by Dupree, one can use the method of reacting an acrylamide functional/alkoxy silane with these polydiorganosiloxanes in the presence of a condensation catalyst such as organotitanates to make the mono-acrylamide functional endblocked polydiorganosiloxane (B). Similarly, other methods can be used to make various kinds of (B) polydiorganosiloxanes such as those described for making the acrylamide functional endblocked polydiorganosiloxane of (A), except that the starting ingredients include a precursor for providing some non-functional endblocking groups. It is possible to prepare directly a composition having the mole percentage values of (A), (B) and (C) within the limits stated above by using such methods.

The non-functional endblocked polydiorganosiloxanes of (C) are well known in the art and can be obtained commercially. These non-functional polydiorganosiloxanes are also produced by the methods of making polydiorganosiloxanes of (B) which use equilibration techniques.

As stated above, the mole percentages of (A), (B) and (C) are such that (A) is present in amounts to provide 4 to 90 mole percent, (B) is present in amounts to provide 9 to 50 mole percent and (C) is present in amounts to provide from 0 to 65 mole percent. Those compositions having a blend with zero mole percent (C) can be prepared by techniques which use non-equilibration methods for preparing the polydiorganosiloxanes such as the living polymer method in which a mixture of cyclic trimers of cyclic poly(methylphenylsiloxane) or cyclic poly(diphenylsiloxane) and cyclic poly(dimethylsiloxane) is polymerized with alkyl lithium. Such methods can produce polydiorganosiloxanes with one hydroxyl endblock and one triorganosiloxy endblock. The blends of this invention are those which are composed of (A), (B) and (C) to provide 20 to 95 percent of the endblocks as acrylamide functionality and 5 to 80 percent of the endblocks as non-functional. The preferred blends contain 45 to 80 percent acrylamide functional endblocks and 20 to 55 percent non-functional endblocks.

The polydiorganosiloxanes of (A) and (B) can be made by a method known as Michael addition if the appropriate precursors are used, namely amine endblocked polydiorganosiloxanes. Such polymers are used where there is an amine on both ends of the polydiorganosiloxane to make (A) and where there is an amine on only one end of the polydiorganosiloxane with the other end being non-functional to make (B). Such polydiorganosiloxanes can be used to make the compositions of this invention.

Lee et al. in U.S. Patent No. 4,697,026, issued September 29, 1987, teach acrylamide functional endblocked polydiorganosiloxanes which are made by a Michael addition of diacrylamide or dimethacrylamide functional compounds with primary or secondary amine functional polydiorganosiloxanes. Lee et al. show the preparation of polymers which use the Michael addition method.

Acrylamide functional endblocked polydiorganosiloxanes prepared by the Michael addition method are those having at least one acrylamide functional endblocking siloxane unit of the general unit formula

**Formula III**

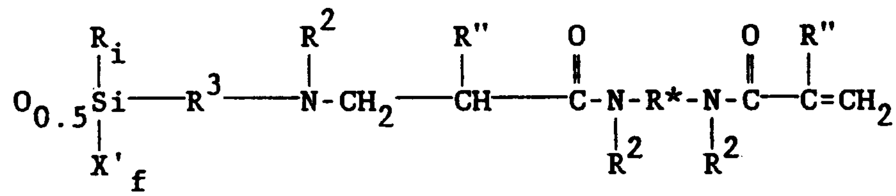

wherein $R^3$, $R^2$, R, R″ and R*, X′ is a hydrolyzable group whose hydrolyzed groups do not form salts with the nitrogen atom, f is 0, 1 or 2, i is 0, 1 or 2 and f + i is two and the repeating siloxane units present in the polydiorganosiloxane are these having the general unit formula $R_2SiO$ in which R is defined above.

For polydiorganosiloxane of (A), one type of preferred Michael addition polydiorganosiloxane containing acrylamide functionality endblocking is one in which f is 0, i is 2, R is methyl, $R^3$ is

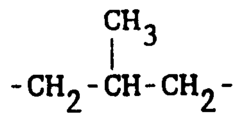 or $-CH_2-CH_2-CH_2-$

$R^2$ is methyl, R″ is hydrogen atom, R* is a divalent hydrocarbon radical of the general formula $-(CH_2)_j-$ in which j is an integer of from 1 to 6 and there is an average of 30 to 3,000 diorganosiloxane units per molecule.

For Michael addition polydiorganosiloxanes of (B), the polymers would be as described above for (A) except that they would have one endblocking triorganosiloxy unit and the other endblocking unit would be the acrylamide functional endblocking siloxane unit of Formula III.

The acrylamide functional endblocked polydiorganosiloxanes of (A) and (B) can be prepared by intimately mixing an amino functional polydiorganosiloxane having endblocking with one primary amine group or secondary amine group per polymer terminal with an acrylamide functional compound having two acrylamide or methacrylamide groups per molecule. When the amine polydiorganosiloxane and acrylamide compound are mixed, there is a reaction which produces acrylamide functional endblocked polydiorganosiloxane and depending upon the amine precursor, whether it has an amine function on both ends or only one end will determine whether it is a polydiorganosiloxane of (A) or (B). This reaction is known as the Michael-type addition reaction. This reaction occurs at room temperature but is rather slow for many commercial applications, for example, the reaction may take as long as 24 hours or more to convert only 40% of the amine to the acrylamide functionality.

Heating the mixture increases the rate of the reaction and at 70 °C. as much as 80% of the amine can be converted to the acrylamide functionality. The mixture should not be heated above 100 °C. because temperatures above 100 °C. can cause considerable loss of the acrylamide functionality due to a free radical initiated chain reaction. Free radical scavengers, such as p-methoxy-phenol, are useful to inhibit the unwanted chain reaction, but these scavengers also inhibit the reactivity of the final acrylamide functional endblocked polydiorganosiloxane during its use, unless they are removed. Although free radical scavengers can be used, their use would add expense to making high purity acrylamide functional endblocked polydiorganosiloxanes.

The best reaction conditions are those in which the intimate mixture is formed using a promoter solvent, such as an alcohol. The preferred alcohols are those which can readily be removed from the reaction product without having to heat it to too high of a temperature. Examples of promoter alcohols are ethanol and isopropanol. The use of the promoter solvent can increase the rate of the reaction such that 90 to 95% of the amine is converted to the acrylamide functionality. The fastest reactions would be those using a promoter solvent and heating the mixture to a temperature above 25 °C. and below 100 °C.

This method offers the advantage that the acrylamide functional endblocked polydiorganosiloxane can be prepared in the desired structural form before the acrylamide functionality is in place on the molecule. The amine functional endblocked polydiorganosiloxane can withstand the higher temperatures of preparation than if the acrylamide functionality would be present on the precursors used in preparing the polydiorganosiloxane. For example, the preparation of poly(co-diphenyl-siloxane-co-dimethylsiloxane) requires an alkaline equilibration catalyst with heating to high temperatures, such as 150 °C., of a mixture of cyclopolydimethylsiloxane and cyclopolydiphenylsiloxane. The preparation of a polymer having dimethylsiloxane units, diphenylsiloxane units and siloxane terminating units having acrylamide functionality could not survive the reaction without causing the acrylamide functionality to polymerize and thus an acrylamide functional polydiorganosiloxane of this type could not be produced. For example, a mixture of cyclopolydimethylsiloxane, cyclopolydiphenylsiloxane, alkaline equilibration catalyst and an amine bearing siloxane precursor could be used to make an amine functional endblocked poly(co-diphenylsiloxane-co-dimethylsiloxane) which could then be converted into an acrylamide functional endblocked polydiorganosiloxane at a lower temperature. The amine functionality can survive such reactions much more readily than the acrylamide functionality.

The amine functionality can be either primary or secondary. The primary amine functionality reacts much more readily than the secondary amine functionality. For this reason, the di-functional acrylamide compounds readily react with primary amine and the remaining amine hydrogen atom does not readily react with the acrylamide functional group. Such a difference in reaction rates between the primary and secondary amines can be used to advantage in the preparation of acrylamide functional endblocked polydiorganosiloxanes of either (A) or (B). After one of the acrylamide groups of the di-functional compound reacts with the primary amine, the reaction can be stopped by adding monofunctional acrylamide compounds to react with the remaining secondary amine hydrogens.

The reaction between the amine functional endblocked polydiorganosiloxane and the di-functional acrylamide compound can be stopped by adding a monofunctional acrylamide or monofunctional acrylate compound to the reaction mixture. The monofunctional acrylamide compound can be added at two points during the reaction. The amine functional endblocked polydiorganosiloxane and the difunctional acrylamide compound can be mixed and at the point one wishes the reaction stopped, the mono-functional acrylamide compound is added. One could also add the monofunctional acrylamide compound at the beginning of the reaction, but this uses up amine hydrogen atoms, especially primary amine hydrogen atoms. The monofunctional acrylamide compound is preferably added after the reaction has begun so that the monofunctional acrylamide compounds do not compete with the difunctional acrylamide compounds in such a manner that the number of acrylamide groups on the final silicon compound is not the desired product.

The reaction can also be stopped by another method in which the reaction between the di-functional acrylamide compound and the amine functional endblocked polydiorganosiloxane is stopped by adding an acid anhydride. Using the acid anhydride to stop the reaction, has the same benefits as using a monofunctional acrylamide compound with respects to shelf stability, but the use of the acid anhydride has the added advantage that a new compound is formed, namely one in which the acrylamide functional endblocked polydiorganosiloxane has the following group

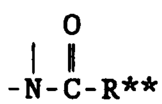

wherein R** is a monovalent hydrocarbon radical or a radical of the general formula $-R^3-COOH$ in which $R^3$ is defined above.

The amounts of amine functional endblocked polydiorganosiloxane and the acrylamide functional compound should be such that there is at least one molecule of acrylamide functional compound per two primary amine hydrogens or one secondary amine hydrogen (wherein these primary and secondary hydrogen atoms are before any reaction with the difunctional acrylamide compound begins). The foregoing ratio of acrylamide functional compound to primary amine hydrogen does not mean that the secondary amine hydrogen atoms do not react but only that they react slower and can be readily stopped from reacting by the above mentioned methods.

The amine functional endblocked polydiorganosiloxane can be any of those known in the art which they primary and secondary amine functionality at the chain terminals. These amine functional polydiorganosiloxanes can be prepared by methods well-known in the art and many are commercial available.

Amine functional silanes used to make the endblocked polydiorganosiloxanes are exemplified by the following general formula

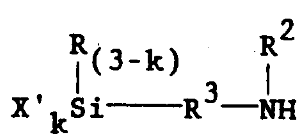

wherein $R^3$, $R^2$, R and X′ are defined above and $\underline{k}$ is 1, 2 or 3. X′ is illustrated by an alkoxy radical or an N,N-dialkylamino radical. Examples of alkoxy radical are methoxy, ethoxy, propoxy, butoxy, 2-ethylhexoxy, isopropoxy, hexyloxy, 2-methoxyethoxy and 2-ethoxyethoxy. Examples of N,N-dialkylamino radicals are dimethylamino, diethylamino and diisopropylamino. Examples of such silanes are gamma-aminopropyltriethoxysilane, gamma-aminopropylmethyldiethoxysilane, gamma-aminopropylethyl-diethoxysilane, gamma-aminopropylphenyldiethoxysilane, delta-aminobutyltriethoxysilane, delta-aminobutylmethyldiethoxysilane, delta-aminobutylethyldiethoxysilane, delta-aminobutylphenyldiethoxysilane, gamma-aminoisobutylmethyldimethoxysilane, aminomethyltrimethoxysilane, gamma-aminopropyltrimethoxysilane, N-methyl-gamma-aminopropyltrimethoxysilane, gamma-aminopropyl-tripropoxysilane, gamma-aminopropyltri(methoxyethoxy)-silane, beta-aminoethyltriethoxysilane, gamma-aminobutyltriethoxysilane, N-methyl-gamma-aminopropylmethyldibutoxysilane, delta-aminobutyltrimethoxysilane, delta-aminobutyldimethylmethoxysilane, beta-aminopropyltriethoxysilane N-butyl-gamma-aminopropyltrimethoxysilane and N-methyl-beta-aminopropyltriethoxysilane. Examples of N,N-dialkylamino silanes are gamma-aminopropyltris(N,N-dimethylamino)silane and gamma-aminopropyl-tris(N,N-diethylamino)silane. These silanes can be used to endblock the polydiorganosiloxane to provide the amine functional endblocked polydiorganosiloxanes which can be used to make acrylamide functional endblocked polydiorganosiloxanes of (A) or (B).

An example of amine functional endblocked polydiorganosiloxane for making acrylamide functional endblocked polydiorganosiloxane of (A) is one of the following formula

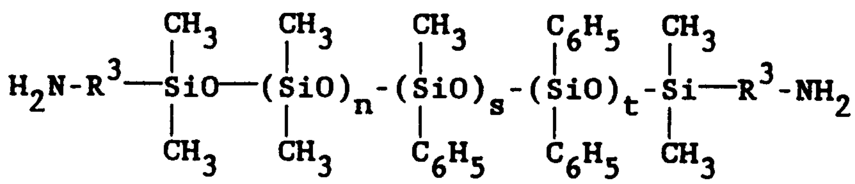

in which $R^3$ is defined above, $\underline{s}$ and $\underline{t}$ have values such that each separately or in combination provide 5 to 50 mole percent phenyl based on the total number of methyl and phenyl and the average value of $\underline{s}+\underline{t}+\underline{n}$ is from 30 to 3,000, preferably from 50 to 1,000. An amine functional endblocked polydiorganosiloxane for making acrylamide functional endblocked polydiorganosiloxanes of (B) is one having the following general formula

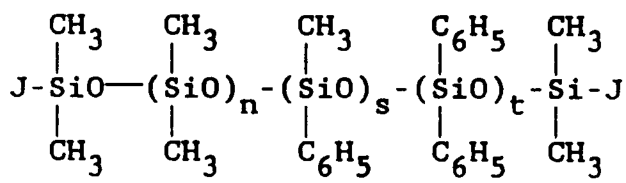

in which $\underline{n}$, $\underline{s}$ and $\underline{t}$ are defined above; one J is methyl and one J is $-R^3-NH_2$ or $-R^3-NHR^2$.

The di-functional acrylamide compounds used to make the acrylamide functional endblocked polydiorganosiloxane are available commercially or can be made by well-known methods. Examples of the difunctional acrylamide compounds include

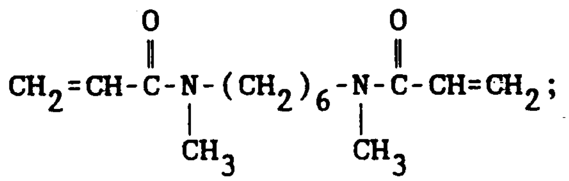

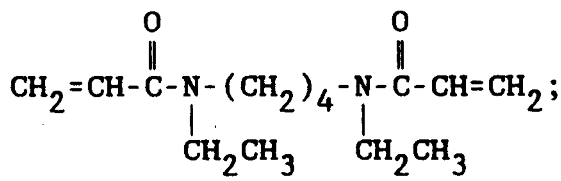

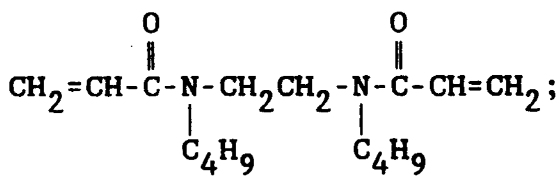

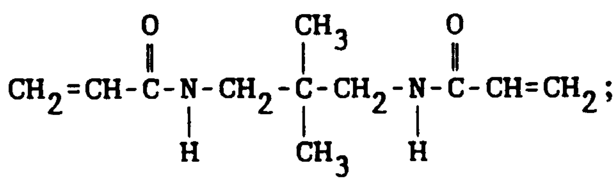

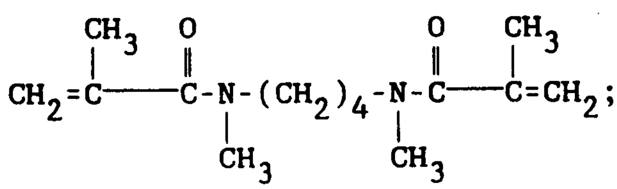

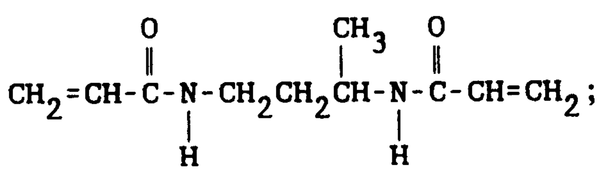

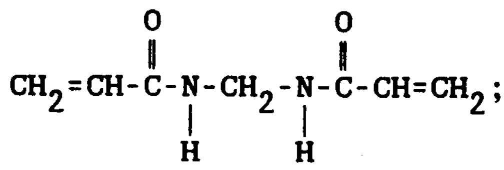

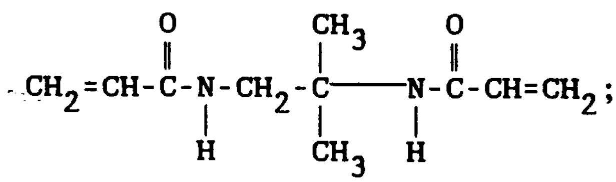

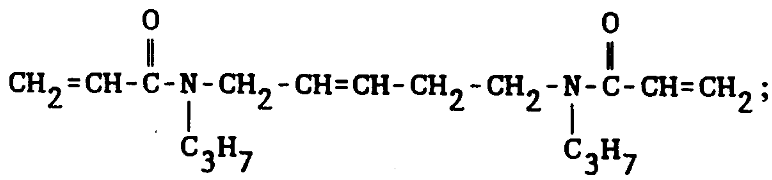

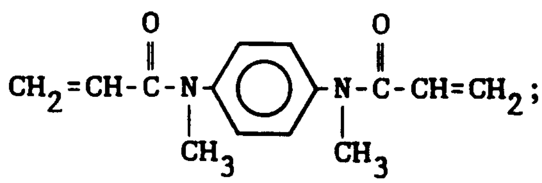

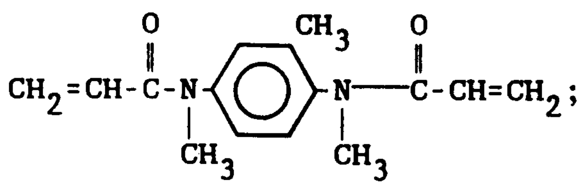

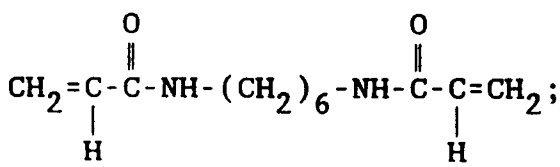

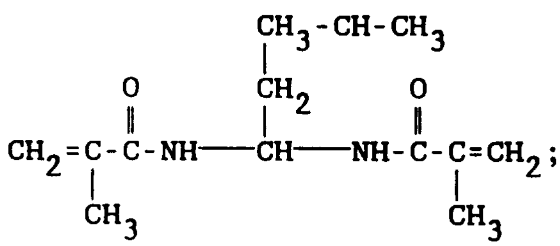 and

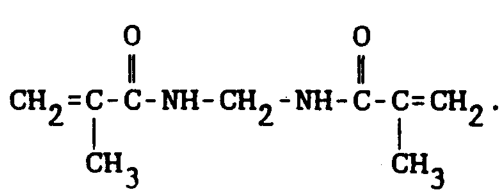

N,N′-dimethylacrylamide can be used to stop the reaction between the di-functional acrylamide compound and the amine functional endblocked polydiorganosiloxane. The anhydrides which can also be used to stop the reaction are illustrated by acetic anhydride, propionic anhydride, butyric anhydride, isovaleric anhydride, caproic anhydride, palmitic anhydride, stearic anhydride, succinic anhydride and glutaric anhydride.

Silanes which have the acrylamide functionality can be used to prepare the acrylamide functional endblocked polydiorganosiloxane of either (A) or (B) by reacting the silane with the hydroxyl endblocked polydiorganosiloxane in the presence of a condensation catalyst as described above. Such silanes can be of the following general formula

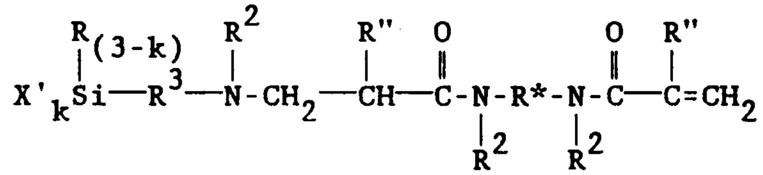

wherein $R^3$, $R^2$, R, X′, R″, R* and k are defined above. Preferably, $R^3$ is an alkylene radical of 3 to 10 carbon atoms, R is methyl, X′ is $OR^9$, R″ is hydrogen, R* is a divalent hydrocarbon radical and k is 3.

The gel compositions comprise the blend of polydiorganosiloxanes (A), (B) and (C) and a photosensitization system which comprises a photoinitiator useful in curing the acrylamide functional endblocked polydiorganosiloxanes to form a gel with a hardness and modulus suitable for encapsulating and/or coating electronic devices which have fragile components. The compositions are cured by exposure to ultraviolet radiation.

The gel compositions comprising the heat stability additive, the blend and photoinitiator are reasonably stable during storage but for additional protection and for exceptional situations one may find it advantageous to add a storage stabilizer. The compositions can contain a storage stabilizer including amines, particularly tertiary amines such as diisopropylaminoethanol and trioctylamine. Another type of viscosity stabilizer is the free radical scavenger type, such as p-methoxyphenol (also known as monomethyl ether of hydroquinone), catechol, 4-t-butylcatechol, phenothiazine, hydroquinone, 2,6-di-t-butyl-p-methylphenol and N-phenyl-2-naphthylamine. The free radical scavenger viscosity stabilizers are used in amounts of preferably zero to one weight percent based on the weight of the composition. If free radical scavenger is used the amounts should be small such as from 0.001 to 0.1 weight percent.

Compositions of this invention can contain optional ingredients which may be suitable for some applications, however, those which effect the cured and the properties of the cured material should be evaluated for suitability to the specific application. In those applications in which the viscosity of the uncured material, electrical properties, corrosive nature of the composition both uncured and cured are important, the kind of optional ingredient should be carefully evaluated, especially when the compositions are to be used as a coating, encapsulant or potting compound for fragile electronic devices. Examples of optional ingredients which might be considered include surfactants, reinforcing agents such as fillers and resins, colorants and other property modifiers.

The compositions of this invention can be used in many kinds of applications in which curing by ultraviolet radiation is acceptable. Particularly suitable applications are those in which electrical and electronic equipment is to be protected such as for coating, encapsulating or potting electronic devices. The compositions of this invention cure to products which vary from hard resin type materials to elastomeric materials to soft gel materials. Some of the compositions are useful for paper coatings. Because the acrylamide functional polyorganosiloxanes of this invention are unique in their ability to form compatible compositions with a wide variety of non-silicon compounds, the kinds of cured products will vary widely in both physical and chemical properties and therefore the use to which they can be put will also vary widely. The compositions of this invention exhibit the characteristic that they maintain many of their properties at low temperature, such as -110 °C. flexibility.

The gel compositions of this invention are of particular interest because they rapidly cure when exposed to ultraviolet radiation, usually in a few seconds and because they are based on polyorganosiloxane, they are suitable for integrated circuit protection. These compositions have excellent purity, low moisture uptake, provide stress relief even at low temperatures, have excellent electrical properties, are thermally stable and can protect against harsh environments. Because of the nature of the gel compositions to independently vary the viscosity and the hardness, they are useful for photobarrier processing involving

"in-situ" generation of flow barriers during material application and photoimaging to allow wafer stage application of permanent protective coatings. The compositions are shelf stable and can be shipped as a one package container product. The gel compositions can be used to protect integrated circuits and can be used in manufacturing where rapid processing is needed, such as automated production lines.

The invention is illustrated by the following examples. In the examples, "part" or "parts" represents "part by weight" or "parts by weight" and the viscosity is measured at 25 °C. unless otherwise stated.

Example 1

A. An acrylamide functional polydimethylsiloxane is designated Acrylamide-polymer A and had the following average formula

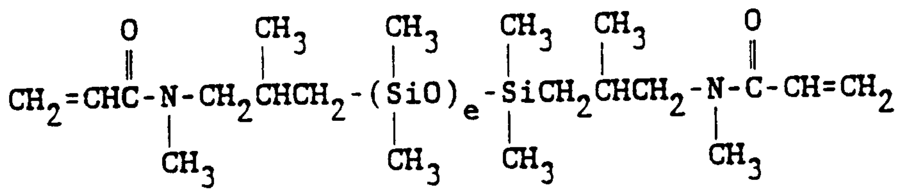

in which e had an average value of about 90.

B. An amino functional endblocked polydiorganosiloxane was prepared by charging into a 5-liter, 3-necked flask equipped with a thermometer, nitrogen purge, stirrer, condenser and bubble tube, 443.31 g of poly(methylphenylsiloxane) cyclics having from 3 to 6 methylphenylsiloxane units per molecule and 2914.43 g of poly(dimethylsiloxane) cyclics having from 3 to 6 dimethylsiloxane units per molecule. In a separate container, 0.77 g of potassium hydroxide, 1.77 g of water, 17.5 g of dimethylformamide, 12.53 g of trimethylsiloxy endblocked polydimethylsiloxane having a viscosity of 2 x 10-6 $m^2/s$ (2 centistrokes) and 27.97 g of a silane of the formula were added with agitation in the order stated to hydrolyze the silane. The mixture exhibited an exotherm and developed a yellow color. After 30 minutes, the hydrolyzed mixture was added to the contents of the 5-liter flask along with 100 g of poly-(dimethylsiloxane) cyclics used to wash the container. The mixture in the flask was heated to 151 °C. and this temperature was maintained about 18 hours. After the temperature cooled to 51 °C., 1.56 cc of propionic acid was added. After standing overnight, 1.76 g of sodium bicarbonate was added, the mixture was stripped to 170 °C. at less than 1.33 kPa (10 mm of Hg), added 35.4 g of Supercell™, as a filtering aid and then the mixture was pressure filtered. The resulting product was a transparent fluid with a faint yellow color. The amino functional endblocked polydiorganosiloxane had an average formula

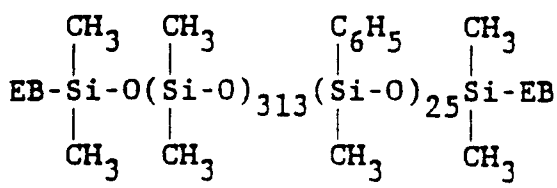

in which EB represents the endblocking in this polymer mixture. The mixture contained according to calculated values, 56.25 mole percent of the polymer molecules having two amino functional endblocking groups of the formula

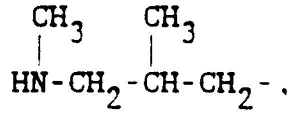

37.5 mole percent of the polymer molecules having one EB being the amino functional radical as shown above and the other EB group being methyl (non-functional) and 6.25 mole percent of the polymer

molecules being endblocked with methyl groups (non-functional). The amino-functional endblocked polydiorganosiloxane was designated Amino-blend A and had 75 percent of the endblocking groups as amino groups and 25 percent of the endblocking groups as methyl groups. Amino-blend A had a viscosity of 8.840 Pas (8,840 centipoise) as measured with a HAF #3 spindle at 10 rpm on a Brookfield viscometer as measured in accordance with ASTM-D1084B and an ANE (amine neutralization equivalent) of 20,020 g/eq.

C. Amino-blend B was prepared as described above except the amounts were varied to provide 75 percent of the endblocking groups as amino groups and 25 percent of the endblocking groups as methyl groups. Amino-blend B had an average formula

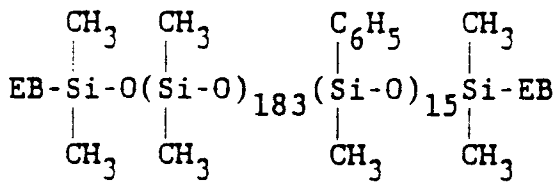

in which EB represents the endblocking in this polymer mixture. Amino-blend B was prepared so as to provide 7.5 mole percent of the siloxy groups having phenyl groups and 92.5 mole percent of the siloxy groups having methyl. The mixture contained according to the calculated values, 56.25 mole percent of the polymer molecules having two amino functional endblocking groups of the formula

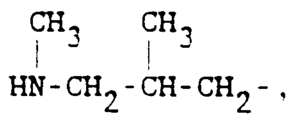

37.5 mole percent of the polymer molecules having one EB being the amino functional radical as shown above and the other EB group being methyl (non-functional) and 6.25 mole percent of the polymer molecules being endblocked with methyl groups (nonfunctional). Amino-blend B had a viscosity of 2.700 Pas (2,700 centipoise) as measured with a HAF #3 spindle at 10 rpm on a Brookfield viscometer and an ANE (amine neutralization equivalent) of 11,450 g/eq.

D. An acrylamide functional endblocked polydiorganosiloxane was prepared by adding to a 5-liter, 3-necked flask, 800 g of Amino-blend A, 800 g of Amino-blend B, 1600 g of hexane and 6.68 g of sodium methoxide. The mixture was cooled to 0 ° C. and then 9.82 cc of acryloyl chloride in 100 cc of hexane was added in seven minutes at which time the temperature of the mixture was -2 ° C. After about 2 hours, 0.95 g of KOH was added. After 1.5 hours, an additional 0.12 g KOH was added. The resulting mixture had an ANE of 164,000 g/eq which represented a 90.5 % conversion. The contents of the flask was cooled to 0 ° C. and 0.68 g of sodium methoxide was added for additional conversion and 1.14 cc of acryloyl chloride in 12 cc of hexane was added over a 2 minute period. After 2 hours, 1.07 g of KOH was added. After 2 hours, an additional 0.45 g KOH was added and the resulting mixture was filtered giving a resultant product with an ANE of 108,600 g/eq for a 86.6 % yield. Then, 1 weight percent sodium bicarbonate, 1 weight percent calcium carbonate and 2 weight percent Supercell™ was added, the mixture was then filtered to yield a clear product. To the resulting product, 50 ppm 4-methoxyphenol (10 weight percent solution in toluene) was added before vacuum stripping to 50 ° C. at less than 1.33 kPa (10 mm of Hg). The product was then rolled overnight with an additional 1 weight percent sodium bicarbonate, 1 weight percent calcium carbonate and 1 weight percent Supercell™. The resultant product after filtering provided Acrylamide-polymer B which had a viscosity of 5 Pas (5,000 centipoise) measured with HAF #3 spindle at 10 rpm. The ANE of Acrylamide-polymer B was 55,300 g/eq for a 71.8% conversion. Acrylamide-polymer B had 75 percent of the endblocking groups as acrylamide functional groups and 25 percent of the endblocking groups as methyl groups.

E. An amino functional endblocked polydiorganosiloxane was prepared by charging into a 3-liter, 3-necked flask equipped with a thermometer, nitrogen purge, stirrer, condenser and bubble tube, 507.4 g of poly(methylphenylsiloxane) cyclics having from 3 to 6 methylphenylsiloxane units per molecule and 966.82 g of poly(dimethylsiloxane) cyclics having from 3 to 6 dimethylsiloxane units per molecule, 0.19 g of potassium hydroxide, 1.5 g of water, 7.5 g of dimethylformamide and 24.26 g of a silane of the

formula

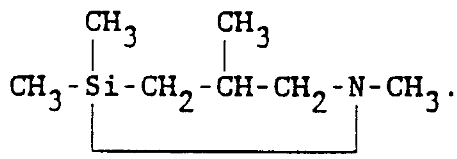

The mixture in the flask was heated to 150 ° C. and this temperature was maintained for about 24 hours. After the temperature cooled to about 50 ° C., 0.4 cc of propionic acid was added. After 2 hours, 0.45 g of sodium bicarbonate and 15 g Supercell™, as a filtering aid, was added and then the mixture was pressure filtered. The mixture was then vacuum stripped to 170 ° C. at less than 1.33 Pa (10 mm of Hg). The resulting product was a transparent fluid. The amino functional endblocked polydiorganosiloxane had an average formula

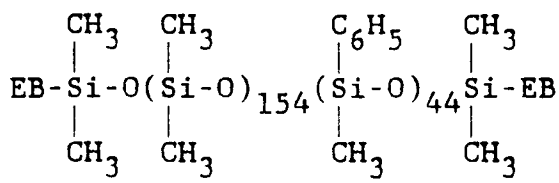

in which EB represents the endblocking in this polymer mixture. Amino-polymer C was prepared to provide a polymer with 22 mole percent siloxy groups being phenyl and 78 mole percent of the siloxy groups being methyl. The mixture contained 100 mole percent of the polymer molecules having two amino functional endblocking groups of the formula

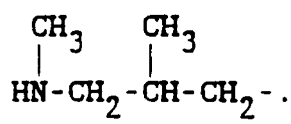

The amino-functional endblocked polydiorganosiloxane was designated Amino-polymer C and had a viscosity of 2.950 Pas (2,950 centipoise) as measured with a HAF #3 spindle at 10 rpm on a Brookfield viscometer as measured in accordance with ASTM-D1084B and an ANE (amine neutralization equivalent) of 8,950 g/eq.

F. An acrylamide functional polydiorganosiloxane (Acrylamide-polymer C) was prepared by mixing in a 5-liter, 3-necked flask equipped with a stirrer, a condenser, a thermometer and an addition funnel, 800 g of Amino-blend C, 2400 cc of methylene chloride, 55 cc of a 2N aqueous sodium hydroxide solution, 40 cc of a 15 weight percent sodium nitrite aqueous solution and 704 cc of water. The temperature was reduced to about 0 ° C. and 8.9 g acryloyl chloride in 14 cc of methylene chloride as added to the stirred Amino-blend C mixture. The addition was completed in about 5 minutes and the reaction was continued for 30 minutes while allowing the temperature to warm to room temperature. The resulting mixture was separated into methylene chloride solution and aqueous solution. The aqueous solution was discarded along with three subsequent water washings of the methylene chloride layer. The methylene chloride solution was put into a freezer overnight, removed, filtered through glass wool to remove ice and then neutralized with calcium carbonate by mixing with 0.5 g of calcium carbonate per 10 g of polymer. The resulting mixture was stirred 2 hours, pressure filtered and then the methylene chloride was removed on a rotary evaporator up to 45 ° C. at less than 1.33 Pa (10 mm of Hg). The resulting product was a hazy fluid with a light yellow color, is designated herein as Acrylamide-polymer C and had an average formula

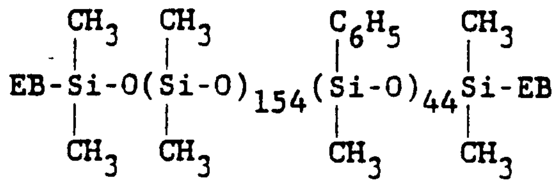

in which EB represents the endblocking in this polymer mixture. The mixture contained 100 mole percent of the polymer molecules having two acrylamide functional endblocking groups of the formula

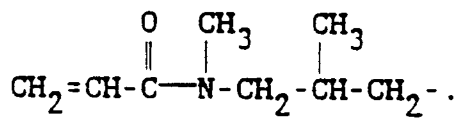

Acrylamid-polymer C had a viscosity of 3.300 Pas (3,300 centipoise) measured in accordance with ASTM-D1084B. The Acrylamide-polymer C had 7.86 weight percent volatiles when heated for 2 hours at 150 ° C.

G. Amino-polymer D was prepared as described above except the amounts were varied to provide 44 mole percent of the siloxy groups being phenyl and 56 mole percent of the siloxy groups being methyl. Amino-blend D had an average formula

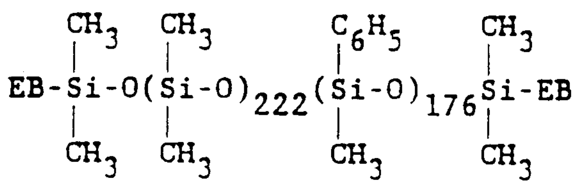

in which EB represents the endblocking in this polymer mixture. The mixture contained 100 mole percent of the polymer molecules having two amino functional endblocking groups of the formula

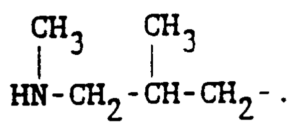

Amino-polymer D had a viscosity of 13.200 Pas (13,200 centipoise) as measured in accordance with ASTM-D1084B.

H. Acrylamide-polymer D was prepared from Amino-polymer D as described above for the preparation of Acrylamide-polymer C. The resulting product had an average formula

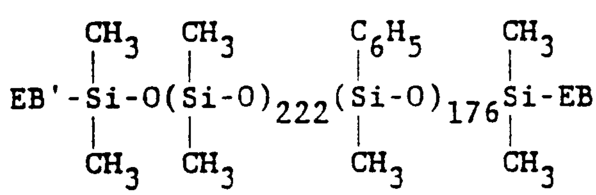

in which EB' represents the endblocking in the polymer mixture. The mixture contained 100 mole percent of the polymer molecules having two acrylamide functional endblocking groups of the formula

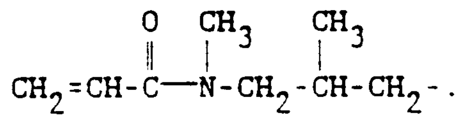

Acrylamide-polymer D had a viscosity of 13,700 centipoise measured in accordance with ASTM-D1084B.
I. Mixtures of Acrylamide-polymer A, Acrylamide-blend B, Acrylamide-polymer C and Acrylamide-polymer D were made with reactive diluents as shown in Table I to determine the compatibility characteristics. The reactive diluents were EHA, 2-ethylhexyl acrylate,

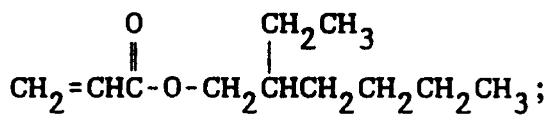

VA, vinyl acetate,

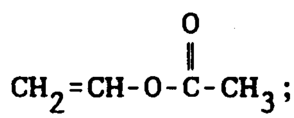

IBA, isobornyl acrylate,

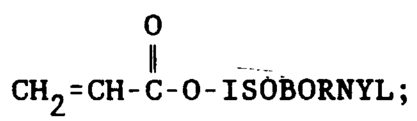

THFA, tetrahydrofurfuryl acrylate,

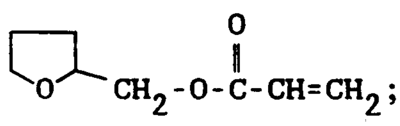

HDDA, 1,6-hexanediol diacrylate,

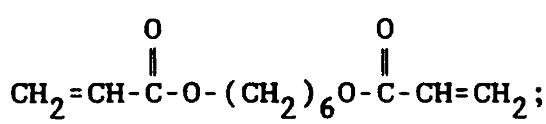

TPGDA, tripropylene glycol diacrylate,

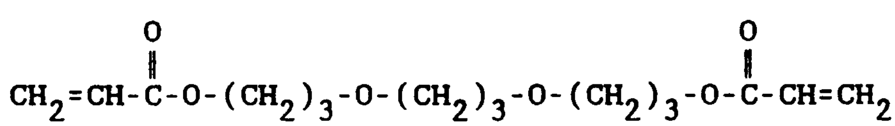

TMPTMA, trimethylolpropane trimethacrylate,

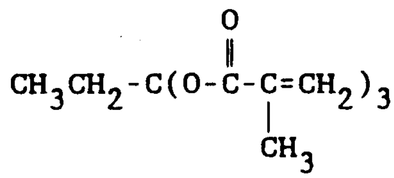

TMPTA, trimethylolpropane triacrylate,

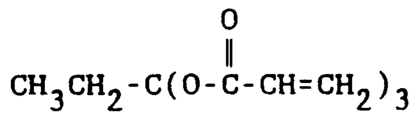

PEA, phenoxyethyl acrylate,

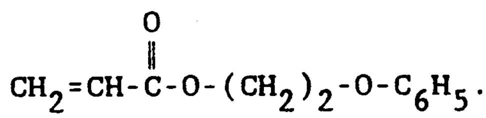

The solubility parameters for the above compounds are shown in Table I in the parentheses following the referenced compound. These solubility parameters were calculated according to the method of Fedors based on group additive constants in R.F. Fedors, Polymer Engineering and Science, 14, No. 2, 147 (February, 1974).

The compatibility of each reactive diluent was determined at two concentrations, 5 weight percent and 30 weight percent based on the weight of the acrylamide functional polyorganosiloxane (such as 6 parts of reactive diluent combined with 20 parts of polymer is 30 weight percent). The mixtures were considered incompatible if they were cloudy or formed two phases. The mixtures and their compatibilities were as reported in Table I where "I" represents "incompatible mixture", "I/C" represents a borderline situation between compatible and incompatible and "C" represents "compatible mixture." Table I shows that the compatibility increases as the phenyl content of the acrylamide functional polydiorganoxiloxane increases from 0 to 44 mole percent.

## TABLE I

| REACTIVE DILUENT | WEIGHT PERCENT | ACRYLAMIDE POLYMER (MOLE % PHENYL) A(0%) | B(7.5%) | C(22%) | D(44%) |
|---|---|---|---|---|---|
| EHA (8.62) | 5 | C | C | C | C |
| | 30 | C | C | C | C |
| VA (8.95) | 5 | C | C | C | C |
| | 30 | C | C | C | C |
| IBA (8.97) | 5 | C | C | C | C |
| | 30 | H | I/C | C | C |
| THFA (9.51) | 5 | H | I/C | C | C |
| | 30 | H | H | C | C |
| HDDA (9.56) | 5 | H | H | C | C |
| | 30 | H | H | C | C |
| TPGDA (9.57) | 5 | H | H | C | C |
| | 30 | H | H | C | C |
| TMPTMA (9.74) | 5 | H | H | C | C |
| | 30 | H | H | C | C |
| TMPTA (9.76) | 5 | H | H | H | C |
| | 30 | H | H | H | H |
| PEA (10.12) | 5 | H | H | H | C |
| | 30 | H | H | H | H |

Example 2

Compositions were prepared by making a physical blend of each of the Acrylamide-polymers A, B, C and D with 5 weight percent of each of the reactive diluents, IBA, HDDA and TMPTMA. To each composition was also added one weight percent of 1-hydroxy-2-methyl-1-phenylpropan-1-one. The resultant compositions were then cured under a medium pressure mercury vapor arc lamp in a UVEXS LCU-750 A UV Cure Unit, manufactured by UVEXS Inc., Mountain View, California. Each pass through this unit provided 400 mJ/cm$^2$ of ultraviolet radiation for cure as measured by an IL 390 Light Bug. The results were as shown in Table II. The compositions which cured faster were those compositions which contain the higher concentration of phenyl and was believed due in part to the improved compatibility.

TABLE II

| REACTIVE DILUENT | PASSES | POLYMER A | POLYMER B | POLYMER C | POLYMER D |
|---|---|---|---|---|---|
| IBA | 1 | CURED | CURED | CURED | CURED |
| HDDA | 1 | SMEARY WAXY | SMEARY CURED | SLIGHT SMEARY CURED | CURED |
| | 2 | CURED | --- | --- | --- |
| TMPTMA | 1 | THIN FILM CURED | THIN FILM CURED | THICK FILM CURED | CURED |
| | 2 | THICKER FILM CURED | ALMOST CURED | CURED | --- |
| | 3 | CURED | CURED | --- | --- |

Example 3

Compositions were prepared by making physical blends of Acrylamide-polymers A, B, C and D with 1-hydroxy-2-methyl-1-phenylpropan-1-one (photoinitiator). The compatibility of the resultant mixtures were examined as the amount of photoinitiator was increased. The results observed were as shown in Table III and illustrated that the amount of photoinitiator can be increased as the amount of phenyl in the acrylamide functional polydiorganosiloxane increased. These mixtures are curable by exposure to ultraviolet radiations

as illustrated in Example 2.

**TABLE III**

| PHOTOINITIATOR, WEIGHT PERCENT | POLYMER A | POLYMER B | POLYMER C | POLYMER D |
|---|---|---|---|---|
| 1 | C | C | C | C |
| 2 | I | I/C | C | C |
| 3 | I | I | C | C |
| 6 | I | I | I | C |

Example 4

Compositions were prepared by making physical blends of Acrylamide-polymers A, B, C and D with one weight percent 1-hydroxy-2-methyl-1-phenylpropan-1-one. Samples of these compositions were then cured as described in Example 2 and the physical appearance at room temperature (about 25 °C.) and after cooling with dry ice to about -78 °C. was observed. The results were as reported in Table IV which shows that the compositions prepared with the acrylamide functional polydiorganosiloxane containing phenyl were softer at the low temperatures.

**TABLE IV**

| POLYMER | PHYSICAL APPEARANCE AT ROOM TEMPERATURE | PHYSICAL APPEARANCE AT -78°C. |
|---|---|---|
| A | TOUGH FILM | CRACKS WHEN BENT |
| B | SOFT GEL | SOFT GEL |
| C | SOFT ELASTOMER | STILL SOFT AND PLIABLE SLIGHTLY STIFF |
| D | ELASTOMER | SOMEWHAT TOUGHER AND STIFFER ELASTOMER |

Example 5

Compositions were made from Acrylamide-polymer B and various compounds which might be considered useful as photosensitization systems. These included

P-1 = 2-hydroxy-2-methylphenylpropan-1-one (Darocur™ 1173)
P-2 = diethoxyacetophenone
P-3 = (1-hydroxycyclohexyl)phenylmethanone (Irgacure™ 184)
P-4 = benzophenone
P-5 = a 50/50 weight mixture of P-1 and diisopropylaminoethanol.

Each of the photosensitization systems were used in an amount of one weight percent except P-5 which was used in an amount of two weight percent. The weight percentage was based on the weight of Acrylamide-blend B. Each of the compositions were cured for a defined period of time by exposure to

ultraviolet radiation on the LCU described in Example 2, set for 3 seconds per pass which measured about 400 mJ/cm$^2$ using a Light Bug. The hardness of the cured composition was measured by using equipment manufactured by instrument MFG Co. on the Shore OO durometer scale using a 6.35 mm (0.25 inch) thick section of the cured material. The durometer was determined initially, after heat aging for 20 hours at 150 °C. in an oven and after 20 hours in an autoclave at 121 °C. and 103 kPa 15 psi pressure. The results were as shown in Table V.

TABLE V

| PHOTOSENSITIZER SYSTEM | CURE TIME SECONDS | DUROMETER INITIAL | DUROMETER HEAT AGED | DUROMETER AUTOCLAVE |
|---|---|---|---|---|
| P-1 | 10 | 45 | 36 | 39 |
| P-2 | 15 | 42 | 30 | 47 |
| P-3 | 5 | 41 | 42 | 40 |
| P-4 | >70 | 44 | 43 | 44 |
| P-5 | 35 | 41 | 42 | 34 |

Example 6

An amino functional endblocked polydiorganosiloxane was prepared as described in Example 1, B. where the ingredients were used as follows: 0.35 part of trimethylsiloxy endblocked polydimethylsiloxane having a viscosity of 2 x 10-6 m$^2$/s (2 centistokes), 0.79 part of a silane of the formula

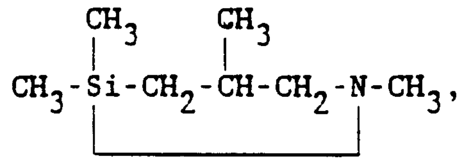

12.47 parts of poly(methylphenylsiloxane) cyclics having from 3 to 6 methylphenylsiloxane units per molecule, 84.8 parts of poly(dimethylsiloxane) cyclics having from 3 to 6 dimethylsiloxane units per molecule, 0.05 part of water (100% of theory) and 0.012 part of potassium hydroxide. 0.49 part of dimethylformamide, 0.024 part of propionic acid, 0.026 part of sodium bicarbonate and 0.98 part of Supercell™. The amino-functional endblocked polydiorganosiloxane had a viscosity of 2 Pas (2,000 centipoise) and an average formula

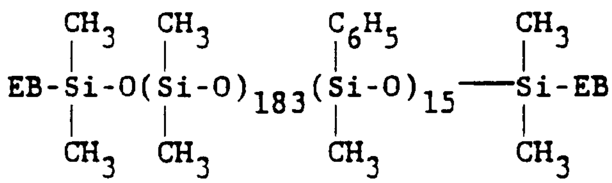

in which EB represents the endblocking in this polymer mixture. The mixture contained according to the calculated values, 56.25 mole percent of the polymer molecules having two amino functional endblocking groups of the formula

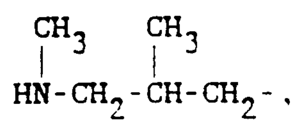

37.5 mole percent of the polymer molecules having one EB being the amino functional radical as shown above and the other EB group being methyl (non-functional) and 6.25 mole percent of the polymer molecules being endblocked with methyl groups (non-functional). This polymer blend is designated Amino-blend G which had 75 percent of the endblocking groups as amino functional and 25 percent of the endblocking groups as methyl (non-functional).

An acrylamide functional endblocked polydiorganosiloxane was prepared as described in Example 1 F. The resulting acrylamide functional endblocked polydiorganosiloxane (which is designated Acrylamide-blend E) had a viscosity of about 2 Pas (2,000 centipoise) and an average formula

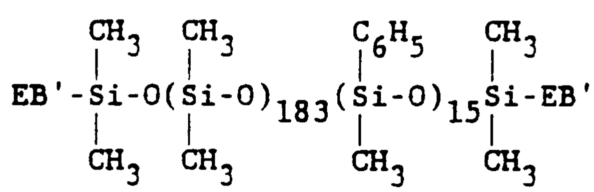

in which EB' represents the endblocking in this polymer mixture. The mixture contained according to the calculated values, 56.25 mole percent of the polymer molecules having two acrylamide functional endblocking groups of the formula

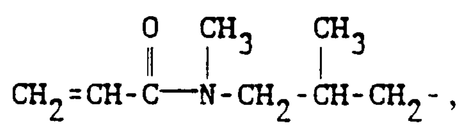

37.5 mole percent of the polymer molecules having one EB' being the acrylamide functional radical as shown above and the other EB' group being methyl (non-functional) and 6.25 mole percent of the polymer molecules being endblocked with methyl groups (non-functional). Acrylamide-blend E had 75 percent of the endblocking groups as acrylamide and 25 percent of the endblocking groups as methyl (non-functional).

A gel composition was prepared by mixing 98 parts of Acrylamide-blend E, 1 part of (1-hydroxycyclohexyl)phenylmethanone and 1 part of a heat stability additive. Sodium and potassium contents were determined on uncured samples of the gel composition by using flame photometry of acid ashed gel composition after removal of silica by treatment with hydrofluoric acid. The amount of sodium and potassium were each less than 2 ppm. The uncured gel composition had a shelf life greater than 6 months and was thus considered to be a one package composition. Test samples of the gel composition were cured by exposure to about 2 $J/cm^2$ dose of ultraviolet radiation emitted by medium pressure mercury vapor arc lamps housed in a UVEXS Model 750A Ultraviolet Curing Unit (LCU) manufactured by UVEXS Inc. of Mountain View, California. The irradiation dose was determined by using an IL 390 Light Bug manufactured by International Light of (Newburyport, Mass.). The durometer was 30 on the Shore OO scale. A sample of cured material exhibited 0.3 weight percent gain after a 24 hour immersion in water at room temperature. As determined by ASTM-D150, the dielectric constant at 100 Hz was 3.0 and at 100.000 Hz was 3.0. As determined by ASTM-D150, the dissipation factor at 100 Hz was 0.006 and at 100,000 Hz was 0.002. The glass transition temperature was -113°C. and there was no melting transition temperature as determined by differential scanning calorimetry. The thermal stability was determined by placing a sample of the cured gel composition in a forced air oven at 150°C. The Shore OO durometer of this gel did not change more than 15% after 1,000 hours of this thermal aging which was considered a good performance. The autoclave stability was determined by placing a sample of cured gel composition in an autoclave at 121°C. with a pressure of 206 kPa (2.1 $kg/cm^2$). The Shore OO durometer of this gel did not change more than 15% in 100 hours autoclave exposure which was considered good performance.

Example 7

A composition was prepared by blending 67 parts of Acrylamide-polymer D, 25 parts of 1,4-butanediol diacrylate, 3 parts of 1-hydroxy-2-methyl-1-phenylpropan-1-one, 5 parts of an adhesion additive, 100 ppm of phenothiazine and 100 ppm of the monomethyl ether of hydroquinone. Samples of the composition were irradiated with ultraviolet radiation at a dosage of about 2 $J/cm^2$ at a wavelength of 250-370 nanometers and an intensity greater than 150 $mW/cm^2$. These compositions cured in between 10 and 20 seconds under a 200 watt/inch medium pressure mercury vapor arc lamp housed in a reflector at a height of 3 inches. This composition was storable in one package for more than six months and had a light yellow hazy appearance with a viscosity between 1.5 and 2.6 Pas (1500 and 2600 centipoise). The ionic purity was determined and there was less than 2 ppm of sodium and less than 2 ppm potassium. The durometer on the Shore OO scale was 80 and on the Shore A scale was 43. These durometer values did not change more than 5% after 150°C. in an forced air oven for 1,000 hours or after 100 hours in an autoclave at 121°C. at a pressure of 206 kPa (2.1 $kg/cm^2$).

## Claims

**1.** A composition comprising a compatible mixture of:

(I) an acrylamide functional polyorganosiloxane having an average unit formula $Y_aR_bSiO_{(4-a-b)/2}$ in which R is a monovalent organic group where 5 to 50 mole percent of R are aromatic based on all R dual to 100 mole percent, Y is an acrylamide functional group bonded to the silicon atom through a silicon-carbon bond, $a$ has a value such that there is on the average at least 0.4 acrylamide functional groups per molecule, $b$ has a value in the range of from 0.7 to 2.02 and the sum of $a+b$ is at least 0.7, said polyorganosiloxane being applicable to a substrate and curable by exposure to ultraviolet radiation, and

(II) a photosensitization system.

**2.** A composition according to claim 1 further comprising a non-silicon-containing reactive diluent.

**3.** The composition according to claim 1 in which said acrylamide functional polyorganosiloxane is a polydiorganosiloxane which has the following average formula $YR_2SiO(R_2SiO)_x(YRSiO)_ySiR_2Y$ where $x$ has a value of at least 10, $y$ can have a value of O or greater, and Y is an acrylamide functional group of the formula:

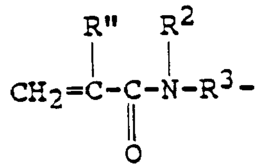

in which R" is hydrogen or methyl, $R^2$ is hydrogen or an alkyl radical of from 1 to 4 carbon atoms, and $R^3$ is a divalent hydrocarbon radical.

## Patentansprüche

**1.** Stoffmischung, enthaltend ein kompatibles Gemisch aus:
(I) einem Acrylamid-funktionalen Polyorganosiloxan mit einer durchschnittlichen Formel für die Einheit

$Y_aR_bSiO_{(4-a-b)/2}$,

in der R einen einwertigen organischen Rest bedeutet und 5 bis 50 Molprozent der Substituenten R aromatisch sind, wobei alle Substituenten R gleich 100 Molprozent gesetzt werden, Y einen Acrylamid-funktionalen Rest bezeichnet, der über eine Silicium-Kohlenstoffbindung an das Siliciumatom gebunden ist, a einen solchen Wert hat, daß durchschnittlich mindestens 0,4 Acrylamid-funktionale Reste pro Molekül vorhanden sind, b einen Wert im Bereich von 0,7 bis 2,02 hat und die Summe von a + b mindestens 0,7 beträgt, wobei das Polyorganosiloxan auf ein Substrat aufgebracht und durch Einwirkung von ultravioletter Strahlung gehärtet werden kann, und
(II) einem Photosensibilisierungssystem.

**2.** Stoffmischung nach Anspruch 1, weiterhin enthaltend reaktives Verdünnungsmittel, das kein Silicium enthält.

**3.** Stoffmischung nach Anspruch 1, wobei das Acrylamid-funktionale Polyorganosiloxan ein Polydiorganosiloxan ist, das die folgende durchschnittliche Formel

$YR_2SiO(R_2SiO)_x(YR\text{-}SiO)_ySiR_2Y$

hat, in der x einen Wert von mindestens 10 hat, y einen Wert von 0 oder größer haben kann und Y einen Acrylamid-funktionalen Rest der Formel

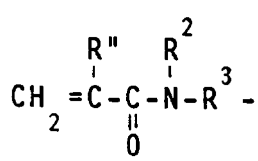

bezeichnet, in der R" Wasserstoff oder Methyl bedeutet, $R^2$ Wasserstoff oder einen Alkylrest mit 1 bis 4 Kohlenstoffatomen bezeichnet und $R^3$ für einen zweiwertigen Kohlenwasserstoffrest steht.

## Revendications

**1.** Une composition comprenant un mélange compatible de :
(I) un polyorganosiloxane à fonctionnalité acrylamide ayant une formule moyenne de motifs $Y_aR_bSiO_{(4-a-b)/2}$ dans laquelle R est un groupe organique monovalent, 5 à 50 modes pour cent des R étant aromatiques par rapport à tous les R représentant 100 modes pour cent, Y est un groupe à fonction acrylamide lié à l'atome de silicium par une liaison silicium-carbone, la valeur de a est telle qu'il y ait en moyenne au moins 0,4 groupe à fonction acrylamide par molécule, la valeur de b se situe dans l'intervalle de 0,7 à 2,02 et la somme a+b est d'au moins 0,7, ledit polyorganosiloxane étant applicable à un substrat et durcissable par exposition à un rayonnement ultraviolet, et

(II) un système de photosensibilisation.

**2.** Une composition selon la revendication 1, comprenant de plus un diluant réactif non silicié.

**3.** La composition selon la revendication 1, dans laquelle ledit polyorganosiloxane à fonctionnalité acrylamide est un polydiorganosiloxane qui répond à la formule moyenne suivante $YR_2SiO(R_2SiO)_x$-$(YRSiO)_ySiR_2Y$ où la valeur de x est d'au moins 10, la valeur de y peut être égale ou supérieure à 0, et Y est un groupe à fonction acrylamide de la formule :

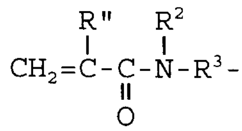

dans laquelle R'' est l'hydrogène ou un groupe méthyle, $R^2$ est l'hydrogène ou un radical alkyle de 1 à 4 atomes de carbone, et $R^3$ est un radical hydrocarboné divalent.